# EUROPEAN PATENT APPLICATION

(11) **EP 4 477 457 A1**
(43) Date of publication of application: **18.12.2024**
(21) Application number: 24178766.2
(22) Date of filing: 29.05.2024
(51) Int. Cl.: B60L 53/30, B60L 53/302, H01R 13/639, H02M 1/00, H05K 7/20, H02M 7/00, H02M 3/00

(54) **CHARGING APPARATUS AND CHARGING DEVICE**

(30) Priority: 31.05.2023 CN 202310641373
(71) Applicant: Huawei Digital Power Technologies Co., Ltd., Shenzhen, Guangdong 518043 (CN)
(72) Inventor: Yang, Zezhou, Shenzhen, Guangdong (CN); Pan, Denghai, Shenzhen, Guangdong (CN); Wang, Qiao, Shenzhen, Guangdong (CN)
(74) Representative: Maiwald GmbH

(57) **Abstract**

This application provides a charging apparatus and a charging device. The charging apparatus includes a plurality of alternating current to direct current conversion AC-DC modules, a plurality of direct current to direct current conversion DC-DC modules, and a power allocation board. The AC-DC module is configured to convert an alternating current into a direct current. The DC-DC module is configured to perform voltage conversion on the direct current output by the AC-DC module. The DC-DC module includes first output ports. The power allocation board includes input terminals, a plurality of switches, and a plurality of second output ports. The plurality of switches are configured to allocate an output power of at least one DC-DC module to at least one of the second output ports. The first output port of the DC-DC module is configured to be in a plug-in connection to the input terminal of the power allocation board. The first output ports are in the plug-in connection to the input terminals, so that an output power of the DC-DC module can be transmitted to the power allocation board. This can avoid wiring between the power allocation board and a conversion unit, and safety is high.

## Description

### TECHNICAL FIELD

This application relates to the field of power supply technologies, and in particular, to a charging apparatus and a charging device.

### BACKGROUND

With the rapid development of the new energy vehicle industry, a charging power of electric vehicles gradually increases, and charging requirements are increasingly diversified. To meet charging requirements of different arriving vehicles and improve power utilization, charging devices are widely used. However, existing charging devices have problems of complex internal wiring, high costs, and low safety.

### SUMMARY

This application provides a charging apparatus and a charging device. The charging apparatus is used in the charging device. The charging apparatus and the charging device provided in this application are intended to reduce complexity of internal wiring of the charging apparatus, to reduce complexity of internal wiring of the charging device. This helps reduce costs of the charging apparatus and the charging device, and helps improve safety of the charging apparatus and the charging device.

According to a first aspect, an embodiment of this application provides a charging apparatus. The charging apparatus includes a plurality of alternating current to direct current conversion AC-DC modules, a plurality of direct current to direct current conversion DC-DC modules, and a power allocation board. The AC-DC module is configured to convert an alternating current into a direct current. The DC-DC module is configured to perform voltage conversion on the direct current output by the AC-DC module, and the DC-DC module includes first output ports. The power allocation board includes input terminals, a plurality of switches, and a plurality of second output ports, and the plurality of switches are configured to allocate an output power of at least one DC-DC module to at least one of the second output ports. The first output port of the DC-DC module is configured to be in a plug-in connection to the input terminal of the power allocation board.

In the charging apparatus provided in this embodiment of this application, the AC-DC module may receive an alternating current output by an external power supply, and convert the alternating current into a direct current. The DC-DC module may receive the direct current output by the AC-DC module, and may perform voltage conversion on the direct current output by the AC-DC module. The first output ports of the DC-DC module are in the plug-in connection to the input terminals of the power allocation board, so that a direct current obtained through the voltage conversion performed by the DC-DC module can be transmitted to the power allocation board. The power allocation board may allocate the output power of the at least one DC-DC module to the at least one of the second output ports by using the plurality of switches. The second output port may output a power supply direct current to an electric device, to supply power to the electric device. The plurality of switches are turned on or turned off, so that output powers allocated to different second output ports can be controlled, and therefore magnitudes of power supply direct currents output by the different second output ports can be controlled. In this way, the charging apparatus can meet power supply requirements of different electric devices. In addition, this helps improve power utilization of the charging apparatus.

The first output ports of the DC-DC module are in the plug-in connection to the input terminals of the power allocation board, so that the direct current obtained through the voltage conversion performed by the DC-DC module can be transmitted to the power allocation board. Such a design has a simple structure, and can avoid complex wiring between the power allocation board and the plurality of DC-DC modules. This helps improve reliability of connections between the power allocation board and the DC-DC modules, thereby greatly improving use safety and manufacturability of the charging apparatus. This also helps reduce processing costs of the charging apparatus. In addition, this helps improve utilization of space between the power allocation board and the plurality of DC-DC modules, and contributes to a miniaturized design of the charging apparatus.

In a possible implementation, the DC-DC module includes a connector. The connector is provided with first output interfaces.

In a possible implementation, the charging apparatus further includes a support member. The support member is configured to limit movement of the first output port of the DC-DC module relative to the input terminal of the power allocation board.

A design of the support member helps improve strength of the plug-in connection between the first output ports and the input terminals, helps improve stability of the connections between the power allocation board and the DC-DC modules, and therefore helps improve structural stability of the charging apparatus.

In a possible implementation, the charging apparatus further includes a fan and a liquid cooling module. The liquid cooling module includes a cooling box, a first pipe, a second pipe, and a heat exchanger. The cooling box is fastened to the heat exchanger through the first pipe and the second pipe. The cooling box is configured to accommodate cooling liquid. The fan is configured for heat emitted by the power allocation board during operation to be absorbed by the cooling liquid. The heat exchanger is configured to perform heat dissipation on the cooling liquid.

The cooling liquid may flow in the cooling box, the first pipe, the heat exchanger, and the second pipe. The fan may be for the heat emitted by the power allocation board during operation to be absorbed by the cooling liquid accommodated in the cooling box, to implement heat dissipation of the power allocation board. The heat exchanger may perform heat dissipation on the cooling liquid that absorbs the heat emitted by the power allocation board during operation, to ensure that the cooling liquid always remains at a relatively low temperature. In this way, the cooling liquid can continuously absorb the heat emitted by the power allocation board during operation, to continuously perform heat dissipation on the power allocation board. In this case, a solution that uses a combination of air and liquid to perform heat dissipation on the power allocation board helps increase a heat dissipation speed of the power allocation board, helps increase a current density of the power allocation board (for example, increase current densities of a plurality of switches), and therefore helps increase the power supply direct current transmitted by the second output port of the power allocation board to the electric device and improve charging efficiency of the charging apparatus. In addition, this helps reduce costs and a size of the power allocation board, contributes to a miniaturized design of the power allocation board, and therefore contributes to the miniaturized design of the charging apparatus.

In a possible implementation, the cooling box includes a heat dissipation pipe. Two ends of the heat dissipation pipe communicate with the first pipe and the second pipe. The cooling liquid flows from the first pipe to the second pipe through the heat dissipation pipe. The fan is configured for the heat emitted by the power allocation board during operation to be absorbed by the cooling liquid flowing in the heat dissipation pipe.

The fan may drive air to flow, so that air with the heat emitted by the power allocation board during operation flows through the heat dissipation pipe. In this way, the heat emitted by the power allocation board during operation can be absorbed by the cooling liquid flowing in the heat dissipation pipe. A structure is simple and easy to design.

In a possible implementation, the charging apparatus further includes a housing. The AC-DC modules and the DC-DC modules are located outside the housing. The power allocation board is accommodated in the housing. The input terminal protrudes from the housing and is in the plug-in connection to the first output port of the DC-DC module.

A design of the housing can prevent a large amount of heat emitted by the power allocation board during operation from spreading to the AC-DC module and the DC-DC module, and therefore avoid affecting operation of the AC-DC module and the DC-DC module.

In a possible implementation, the fan and the liquid cooling module are located outside the housing. The housing is provided with an air outlet and an air inlet. Both the air outlet and the air inlet penetrate through the housing.

During operation of the power allocation board, the power allocation board emits a large amount of heat. As a result, a temperature of air around the power allocation board increases, so that high-temperature gas is formed. The fan may draw air, so that the high-temperature gas is blown out of the housing through the air outlet to the cooling box. In this way, the cooling liquid accommodated in the cooling box absorbs heat from the high-temperature gas, to cool the high-temperature gas. As a result, the heat emitted by the power allocation board is absorbed by the cooling liquid accommodated in the cooling box, so that heat dissipation of the power allocation board is implemented. The heat dissipation manner is simple and easy to design, and has relatively high universality. Air outside the housing may flow into the housing from the air inlet, to ensure balance of air pressure inside the housing.

In a possible implementation, the fan and the cooling box are accommodated in the housing. Both the first pipe and the second pipe are fastened to the cooling box, and protrude from the housing and are fastened to the heat exchanger.

It may be understood that the heat exchanger is located outside the housing. During operation of the power allocation board, the power allocation board emits a large amount of heat and the heat spreads to air inside the housing. The fan may cause the air inside the housing to flow, so that a disturbing flow is formed, and the heat emitted by the power allocation board flows to the cooling box along with the air. In this way, the cooling liquid accommodated in the cooling box can absorb the heat emitted by the power allocation board. The heat exchanger located outside the housing performs heat dissipation on the cooling liquid, to ensure a uniform temperature within the air inside the housing. In this way, even heat dissipation of the air inside the housing is implemented, and even heat dissipation of the power allocation board is implemented.

In a possible implementation, the AC-DC module includes direct current output ports. The DC-DC module includes direct current input ports. The charging apparatus further includes a plug-in member. The plug-in member includes first plug-in portions and second plug-in portions. The first plug-in portion is configured to be in a plug-in connection to the direct current output port of the AC-DC module. The second plug-in portion is configured to be in a plug-in connection to the direct current input port of the DC-DC module.

The first plug-in portions are in the plug-in connection to the direct current output ports of the AC-DC module, and the second plug-in portions are in the plug-in connection to the direct current input ports of the DC-DC module, so that the direct current output by the AC-DC module can be transmitted to the DC-DC module through the plug-in member. A design of the plug-in connection has a simple and stable structure. This helps improve the structural stability of the charging apparatus.

According to a second aspect, an embodiment of this application further provides a charging device. The charging device includes the charging apparatus according to any one of the implementations of the first aspect and a plurality of charging terminals. The charging terminal is configured to electrically connect to the second output port.

A power supply direct current output by the second output port of the charging apparatus is transmitted to an electric device through the charging terminal, to supply power to the electric device.

### BRIEF DESCRIPTION OF DRAWINGS

To describe the technical solutions of embodiments of this application or the background more clearly, the following describes the accompanying drawings used for describing embodiments of this application or the background.
FIG. 1 is a block diagram of a structure of a charging device according to an embodiment of this application;
FIG. 2 is a schematic diagram depicting, in a positive direction of a Y axis, a structure of a charging apparatus according to an embodiment of this application;
FIG. 3 is a schematic sectional view, along an A-A line, of a structure of the charging apparatus shown in FIG. 2;
FIG. 4 is a schematic diagram depicting, in a positive direction of a Y axis, a structure of a protective housing of the charging apparatus shown in FIG. 2;
FIG. 5 is a schematic sectional view, along a B-B line, of a partial structure of the protective housing shown in FIG. 4;
FIG. 6 is a schematic diagram depicting, in a positive direction of a Y axis, structures of a control module, a power distribution component, AC-DC modules, DC-DC modules, and adapting members of the charging apparatus shown in FIG. 2;
FIG. 7 is a schematic sectional view, along a C-C line, of a partial structure of the charging apparatus (with the adapting members and the control module omitted) shown in FIG. 6;
FIG. 8 is a schematic sectional view, along a D-D line, of a partial structure of the charging apparatus (with the adapting members and the control module omitted) shown in FIG. 6;
FIG. 9 is a schematic sectional view, along an E-E line, of a structure of the charging apparatus shown in FIG. 6;
FIG. 10 is an enlarged view of a part X of the charging apparatus shown in FIG. 9;
FIG. 11 is a schematic sectional view, along an F-F line, of a partial structure of the charging apparatus (with a heat dissipation assembly omitted) shown in FIG. 2;
FIG. 12 is a schematic sectional view, along a G-G line, of a partial structure of the charging apparatus (with a heat dissipation assembly and adapting members omitted) shown in FIG. 2;
FIG. 13 is an enlarged view of a part XIII of the charging apparatus shown in FIG. 12;
FIG. 14 is a schematic diagram depicting, in a positive direction of a Y axis, a structure of a power allocation board of the charging apparatus shown in FIG. 2;
FIG. 15 is a block diagram of a partial electrical principle of mating between a control module, a DC-DC module, an adapting member, a power allocation board, and a charging terminal of the charging apparatus shown in FIG. 2;
FIG. 16 is a schematic sectional view, along a G-G line, of a partial structure of the charging apparatus (with adapting members omitted) shown in FIG. 2;
FIG. 17 is an enlarged view of a part XVII of the charging apparatus shown in FIG. 3;
FIG. 18 is a block diagram of a structure of mating between a main body, and a first pipe and a second pipe, of a liquid cooling module of a heat dissipation assembly of the charging apparatus shown in FIG. 17; and
FIG. 19 is a schematic sectional view, along a G-G line, of a partial structure of the charging apparatus (with adapting members omitted) shown in FIG. 2 according to another embodiment.

### DESCRIPTION OF EMBODIMENTS

Embodiments of this application provide a charging apparatus and a charging device. The charging apparatus is used in the charging device. According to the charging apparatus and the charging device provided in embodiments of this application, complexity of internal wiring of the charging apparatus is greatly reduced, so that complexity of internal wiring of the charging device is reduced. This helps reduce costs of the charging apparatus and the charging device, and helps improve safety of the charging apparatus and the charging device.

The following describes embodiments of this application with reference to the accompanying drawings in embodiments of this application.

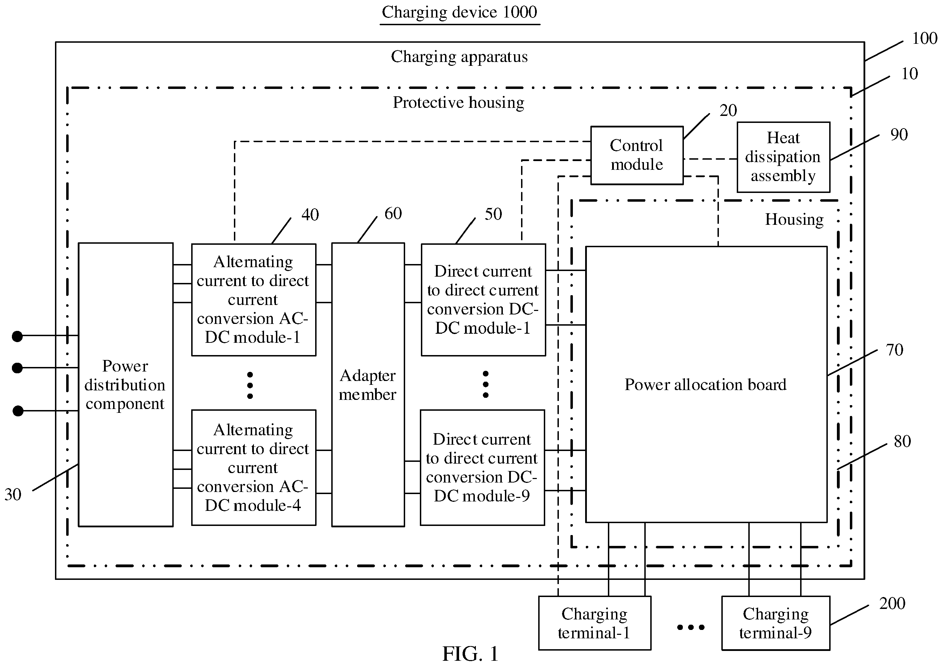

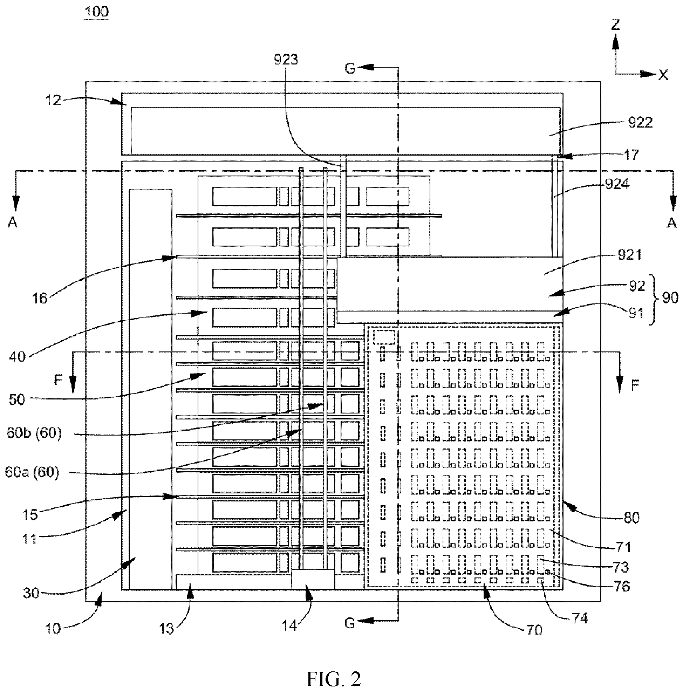

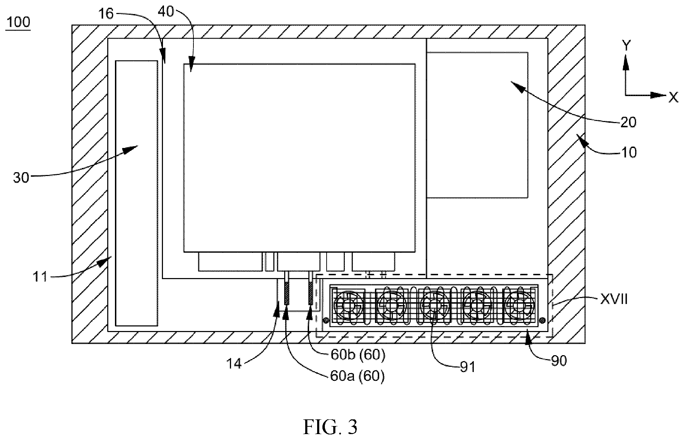

Refer to FIG. 1, FIG. 2, and FIG. 3. FIG. 1 is a block diagram of a structure of a charging device 1000 according to an embodiment of this application. FIG. 2 is a schematic diagram depicting, in a positive direction of a Y axis, an internal structure of a charging apparatus 100 according to an embodiment of this application. FIG. 3 is a schematic sectional view, along an A-A line, of a structure of the charging apparatus 100 shown in FIG. 2.

The charging device 1000 includes the charging apparatus 100 and a plurality of charging terminals 200. The charging apparatus 100 is electrically connected to the plurality of charging terminals 200. For example, there are nine charging terminals 200. In some other embodiments, there may alternatively be two, three, or more charging terminals 200. The charging apparatus 100 may receive an alternating current output by an external power supply, and process the alternating current to output a plurality of power supply direct currents. The charging apparatus 100 may adjust powers of the plurality of power supply direct currents, and the powers of the plurality of power supply direct currents may be the same or different.

The charging terminal 200 is configured to receive one power supply direct current output by the charging apparatus 100. The charging terminal 200 is further configured to electrically connect to an electric device. The electric device may include but is not limited to an electric vehicle, such as a pure electric vehicle, a hybrid vehicle, a fuel cell vehicle, or a tram, or another electronic device that consumes power. The charging terminal 200 may receive the power supply direct current output by the charging apparatus 100, and output the power supply direct current to the electric device, to supply power to the electric device.

As shown in FIG. 1, the charging apparatus 100 includes a protective housing 10, a control module 20, a power distribution component 30, a plurality of alternating current to direct current conversion AC-DC modules 40, a plurality of direct current to direct current conversion DC-DC modules 50, an adapting member 60, a power allocation board 70, a housing 80, and a heat dissipation assembly 90. The control module 20 is configured to control operation of the AC-DC module 40, the DC-DC module 50, the power allocation board 70, and the heat dissipation assembly 90.

The power distribution component 30 is configured to output an external alternating current to the AC-DC module 40. The AC-DC module 40 is configured to convert the alternating current into a direct current. The plurality of DC-DC modules 50 receive, through the adapting member 60, direct currents output by the AC-DC modules 40. The DC-DC module is configured to perform voltage conversion on the direct current output by the AC-DC module 40. The power allocation board 70 is electrically connected to the plurality of DC-DC modules 50 and the plurality of charging terminals 200. The power allocation board 70 may receive direct currents output by the plurality of DC-DC modules 50, and output a plurality of supply direct currents to the plurality of charging terminals 200.

The power allocation board 70 may adjust powers of the plurality of supply direct currents. The power allocation board 70 may allocate an output power of at least one DC-DC module 50 to at least one supply direct current, and can adjust the powers of the plurality of supply direct currents by controlling allocation of output powers of the plurality of DC-DC modules 50. In other words, the power allocation board 70 may allocate the output power of the at least one DC-DC module 50 to at least one charging terminal 200. For example, there are four AC-DC modules 40, and there are nine DC-DC modules 50. In some other embodiments, there may alternatively be two, three, or more AC-DC modules 40, and there may alternatively be two, three, or more DC-DC modules 50. The heat dissipation assembly 90 is configured to perform heat dissipation on the power allocation board 70. The control module 20 is further electrically connected to the plurality of charging terminals 200. The control module 20 may control operation of the plurality of charging terminals 200.

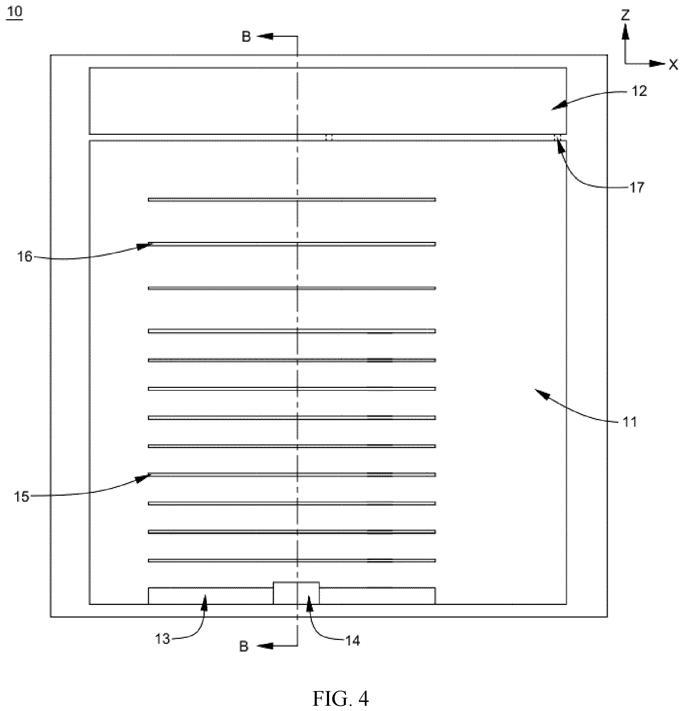

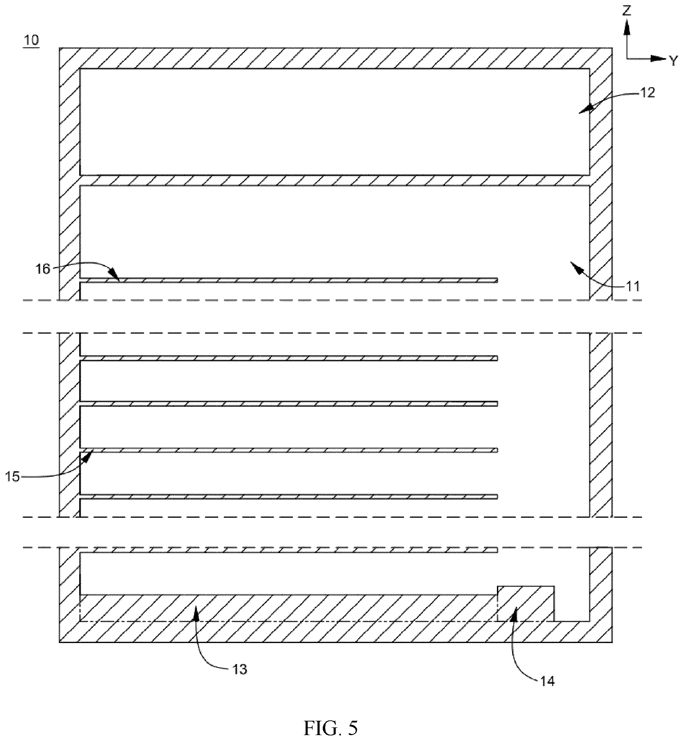

Refer to FIG. 4 and FIG. 5. FIG. 4 is a schematic diagram depicting, in a positive direction of a Y axis, a structure of the protective housing 10 of the charging apparatus 100 shown in FIG. 2. FIG. 5 is a schematic sectional view, along a B-B line, of a partial structure of the protective housing 10 shown in FIG. 4.

For ease of the following description, in this embodiment, a length direction of the protective housing 10 is defined as a first direction (namely, a direction of an X axis shown in the figure), a width direction of the protective housing 10 is defined as a second direction (namely, a direction of a Y axis shown in the figure), and a height direction of the protective housing 10 is defined as a third direction (namely, a direction of a Z axis shown in the figures).

In some embodiments, the protective housing 10 includes a first accommodation cavity 11 and a second accommodation cavity 12. In the direction of the Z axis, the first accommodation cavity 11 and the second accommodation cavity 12 are arranged in sequence and spaced from each other. The protective housing 10 is provided with a support protrusion 13, and the support protrusion 13 is accommodated in the first accommodation cavity 11. The protective housing 10 is provided with a mounting protrusion 14, and the mounting protrusion 14 is accommodated in the first accommodation cavity 11. In addition, in the direction of the Y axis, the mounting protrusion 14 is located on one side of the support protrusion 13, and is connected to the support protrusion 13.

The protective housing 10 is provided with a plurality of first support portions 15, and the plurality of first support portions 15 are accommodated in the first accommodation cavity 11. In the direction of the Z axis, the plurality of first support portions 15 are located on one side of the support protrusion 13, and are spaced from the support protrusion 13. In the direction of the Z axis, the plurality of first support portions 15 are arranged in sequence and spaced from each other. For example, there are eight first support portions 15. In some other embodiments, there may alternatively be two, three, or more first support portions 15.

The protective housing 10 is provided with a plurality of second support portions 16, and the plurality of second support portions 16 are accommodated in the first accommodation cavity 11. In the direction of the Z axis, the plurality of second support portions 16 are located on one side that is of the plurality of first support portions 15 and that faces away from the support protrusion 13, are spaced from the plurality of first support portions 15, and are spaced from inner walls of the first accommodation cavity 11. In the direction of the Z axis, the plurality of second support portions 16 are arranged in sequence and spaced from each other. For example, there are four second support portions 16. In some other embodiments, there may alternatively be two, three, or more second support portions 16.

The protective housing 10 is provided with a plurality of through holes 17. In the direction of the X axis, the plurality of through holes 17 are spaced from each other. In the direction of the Z axis, the through holes 17 extend in the direction of the Z axis, and communicate with the first accommodation cavity 11 and the second accommodation cavity 12. For example, there are two through holes 17.

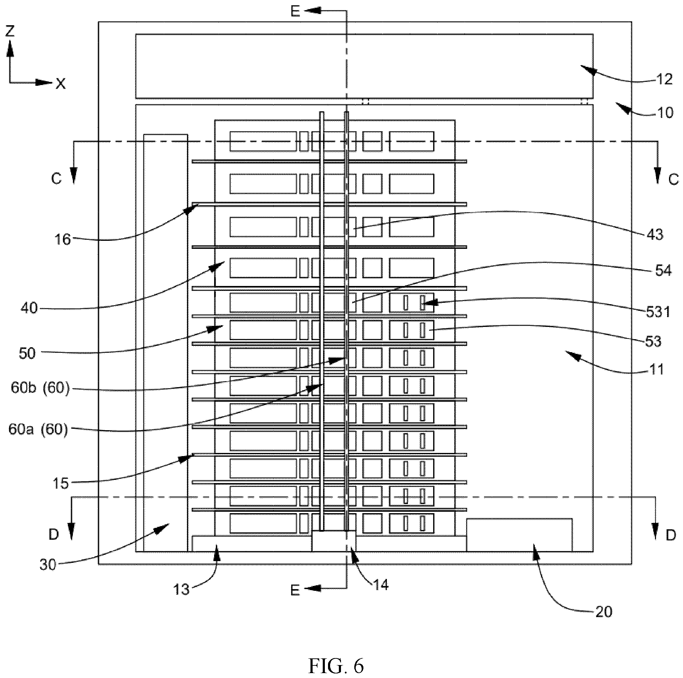

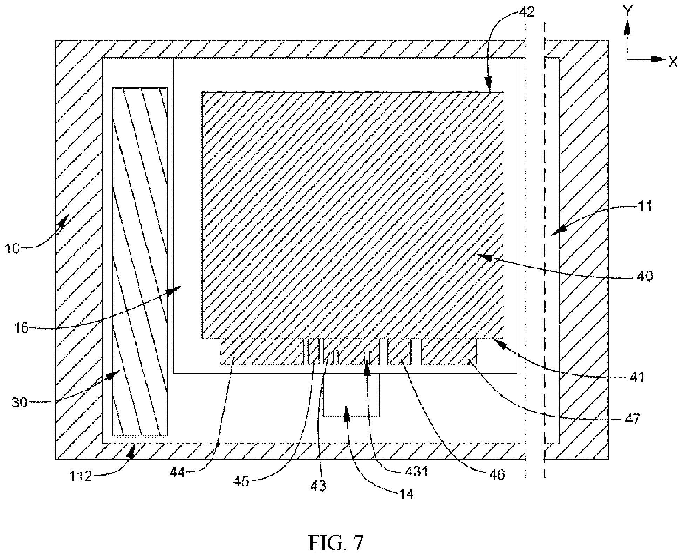

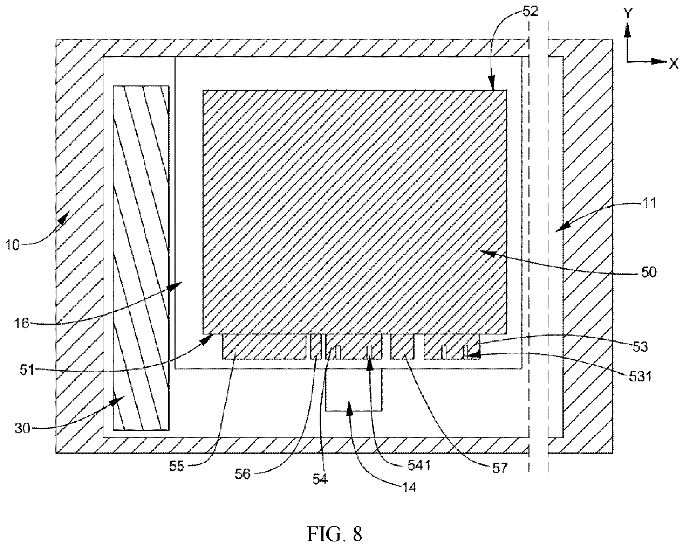

Refer to FIG. 6, FIG. 7, and FIG. 8. FIG. 6 is a schematic diagram depicting, in a positive direction of a Y axis, structures of the control module 20, the power distribution component 30, the AC-DC modules 40, the DC-DC modules 50, and the adapting member 60 of the charging apparatus 100 shown in FIG. 2. FIG. 7 is a schematic sectional view, along a C-C line, of a partial structure of the charging apparatus 100 (with the adapting member 60 and the control module 20 omitted) shown in FIG. 6. FIG. 8 is a schematic sectional view, along a D-D line, of a partial structure of the charging apparatus 100 (with the adapting member 60 and the control module 20 omitted) shown in FIG. 6.

As shown in FIG. 6, both the control module 20 and the power distribution component 30 are accommodated in the first accommodation cavity 11. In the direction of the X axis, the control module 20 and the power distribution component 30 are located on two opposite sides of the support protrusion 13. The plurality of AC-DC modules 40 are accommodated in the first accommodation cavity 11. Specifically, the plurality of AC-DC modules 40 are mounted to the plurality of second support portions 16 in a one-to-one correspondence. For example, the four AC-DC modules 40 are mounted to the four second support portions 16 in a one-to-one correspondence. The AC-DC module 40 is mounted to a surface that is of the second support portion 16 and that faces away from the first support portion 15. It may be understood that, in the direction of the Z axis, the plurality of AC-DC modules 40 are arranged in sequence and spaced from each other.

As shown in FIG. 7, the AC-DC module 40 includes a first surface 41 and a second surface 42. In the direction of the Y axis, the first surface 41 and the second surface 42 face away from each other. The first surface 41 is provided with a first mating connector 43. The first mating connector 43 is provided with direct current output ports 431. In other words, the AC-DC module 40 includes the direct current output ports 431. The direct current output port 431 extends in the direction of the Y axis and has an opening. The opening is located on a surface that is of the first mating connector 43 and that faces away from the first surface 41. The direct current output ports 431 are provided in pairs. For example, there is one pair of direct current output ports 431. In other words, there are two direct current output ports 431. In the direction of the X axis, the two direct current output ports 431 are arranged in sequence and spaced from each other. The AC-DC module 40 outputs a direct current through the two direct current output ports 431.

As shown in FIG. 6 and FIG. 7, the first surface 41 of the AC-DC module 40 is provided with a first connection terminal 44, a first indication terminal 45, a second indication terminal 46, and a second connection terminal 47. In the direction of the X axis, the first connection terminal 44, the first indication terminal 45, the first mating connector 43, the second indication terminal 46, and the second connection terminal 47 are arranged in sequence and spaced from each other. The first connection terminal 44 is configured to electrically connect to the power distribution component 30. The AC-DC module 40 receives, through the first connection terminal 44, an alternating current output by an external power supply. The first indication terminal 45 works with the second indication terminal 46 to indicate a position of the first mating connector 43, to facilitate assembly of the first mating connector 43 and an external component. The second connection terminal 47 is configured to electrically connect to the control module 20.

As shown in FIG. 6, the plurality of DC-DC modules 50 are accommodated in the first accommodation cavity 11. Specifically, the plurality of DC-DC modules 50 are amounted to the plurality of first support portions 15 and the support protrusion 13. For example, among the nine DC-DC modules 50, one DC-DC module 50 is mounted to the support protrusion 13, where the DC-DC module is mounted to a surface that is of the support protrusion 13 and that faces the first support portion 15; and remaining eight DC-DC modules 50 are mounted to the eight first support portions 15 in a one-to-one correspondence, where the DC-DC module 50 is mounted to a surface that is of the first support portion 15 and that faces away from the support protrusion 13. It may be understood that, in the direction of the Z axis, the plurality of AC-DC modules 40 and the plurality of DC-DC modules 50 are arranged in sequence and spaced from each other.

As shown in FIG. 8, the DC-DC module 50 includes a first mounting surface 51 and a second mounting surface 52. In the direction of the Y axis, the first mounting surface 51 and the second mounting surface 52 face away from each other. The first mounting surface 51 is provided with a connector 53. The connector 53 is provided with first output ports 531. In other words, the DC-DC module 50 includes the first output ports 531. That is, the DC-DC module 50 includes the connector 53, and the connector 53 is provided with the first output ports 531. The first output port 531 extends in the direction of the Y axis and has an opening. The opening is located on a surface that is of the connector 53 and that faces away from the first mounting surface 51. The first output ports 531 are provided in pairs. For example, there is one pair of first output ports 531. In other words, there are two first output ports 531. In the direction of the X axis, the two first output ports 531 are arranged in sequence and spaced from each other. The DC-DC module 50 outputs a direct current through the two first output ports 531.

As shown in FIG. 6 and FIG. 8, the first mounting surface 51 of the DC-DC module 50 is provided with a second mating connector 54. The second mating connector 54 is provided with direct current input ports 541. In other words, the DC-DC module 50 includes the direct current input ports 541. The direct current input port 541 extends in the direction of the Y axis and has an opening. The opening is located on a surface that is of the second mating connector 54 and that faces away from the first mounting surface 51. The direct current input ports 541 are provided in pairs. For example, there is one pair of direct current input ports 541. In other words, there are two direct current input ports 541. In the direction of the X axis, the two direct current input ports 541 are arranged in sequence and spaced from each other. The DC-DC module 50 receives, through the two direct current input ports 541, a direct current output by the AC-DC module 40.

In some embodiments, the first mounting surface 51 of the DC-DC module 50 is provided with a third connection terminal 55, a third indication terminal 56, and a fourth indication terminal 57. In the direction of the X axis, the third connection terminal 55, the third indication terminal 56, the second mating connector 54, the fourth indication terminal 57, and the connector 53 are arranged in sequence and spaced from each other. The third connection terminal 55 is configured to electrically connect to the control module 20. The third indication terminal 56 works with the fourth indication terminal 57 to indicate a position of the second mating connector 54, to facilitate assembly of the second mating connector 54 and the external device.

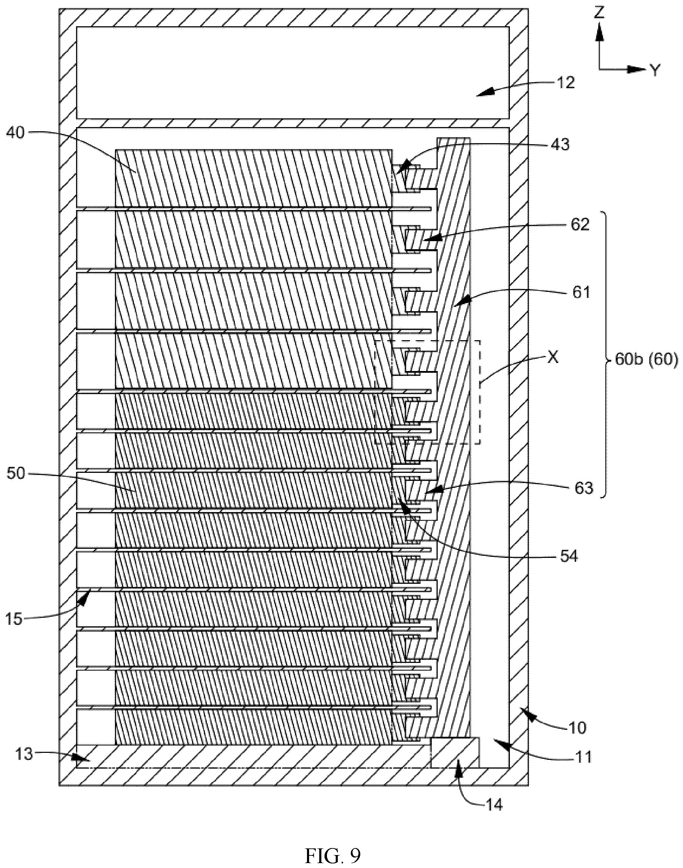

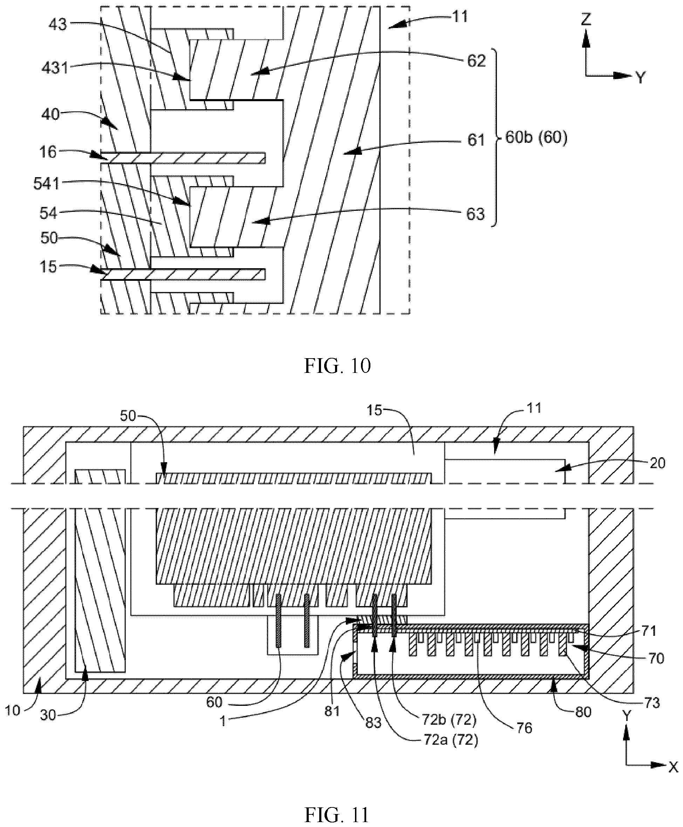

Refer to FIG. 9, FIG. 10, and FIG. 6. FIG. 9 is a schematic sectional view, along an E-E line, of a structure of the charging apparatus 100 shown in FIG. 6. FIG. 10 is an enlarged view of a part X of the charging apparatus 100 shown in FIG. 9.

As shown in FIG. 6 and FIG. 9, in some embodiments, adapting members 60 are accommodated in the first accommodation cavity 11. In the direction of the Y axis, the adapting members 60 are located on one side of the plurality of AC-DC modules 40 and one side of the plurality of DC-DC modules 50, and are connected to the plurality of AC-DC modules 40 and the plurality of DC-DC modules 50. In addition, in the direction of the Z axis, the adapting members 60 are mounted to the mounting protrusion 14. The adapting members 60 are provided in pairs. For example, there is one pair of adapting members 60. In other words, there are two adapting members 60. The two adapting members 60 are a first adapting member 60a and a second adapting member 60b. In the direction of the X axis, the first adapting member 60a and the second adapting member 60b are arranged in sequence and spaced from each other (as shown in FIG. 6). A direct current output by the AC-DC module 40 may flow back to the AC-DC module 40 along the first adapting member 60a, the DC-DC module 50, and the second adapting member 60b, and a current passing path is formed. It should be noted that the connections between the adapting member 60 and the plurality of AC-DC modules 40 and the connections between the adapting member 60 and the plurality of DC-DC modules 50 include electrical connections and fixed connections.

As shown in FIG. 6, FIG. 9, and FIG. 10, for example, the adapting member 60 is made of copper. In some other embodiments, the adapting member 60 may alternatively be made of another conductive material such as aluminum or iron. In some embodiments, the adapting member 60 includes a main body portion 61, first plug-in portions 62, and second plug-in portions 63. Specifically, there are both a plurality of first plug-in portions 62 and a plurality of second plug-in portions 63. In the direction of the Y axis, the plurality of first plug-in portions 62 and the plurality of second plug-in portions 63 are located on one side of the main body portion 61, and are all connected to the main body portion 61. In the direction of the Z axis, the plurality of first plug-in portions 62 and the plurality of second plug-in portions 63 are arranged in sequence and spaced from each other. The main body portion 61, the plurality of first plug-in portions 62, and the plurality of second plug-in portions 63 may be integrally formed. This helps improve overall strength of the adapting member 60 and improve structural stability of the adapting member 60. It should be noted that the connections between the main body portion 61 and the first plug-in portions 62 and the connections between the main body portion 61 and the second plug-in portions 63 include fixed connections and electrical connections.

For example, there are four first plug-in portions 62, and there are nine second plug-in portions 63. Four first plug-in portions 62 of the first adapting member 60a are in a one-to-one plug-in connection to direct current output ports 431 of the four AC-DC modules 40. Four first plug-in portions 62 of the second adapting member 60b are in a one-to-one plug-in connection to the direct current output ports 431 of the four AC-DC modules 40. The first plug-in portion 62 of the first adapting member 60a is in a plug-in connection to one direct current output port 431 of the AC-DC module 40. The first plug-in portion 62 of the second adapting member 60b is in a plug-in connection to the other direct current output port 431 of the AC-DC module 40. In other words, the first plug-in portion 62 is configured to be in the plug-in connection to the direct current output port 431 of the AC-DC module 40.

Nine second plug-in portions 63 of the first adapting member 60a are in a one-to-one plug-in connection to direct current input ports 541 of the nine DC-DC modules 50. Nine second plug-in portions 63 of the second adapting member 60b are in a one-to-one plug-in connection to the direct current input ports 541 of the nine DC-DC modules 50. The second plug-in portion 63 of the first adapting member 60a is in a plug-in connection to one direct current input port 541 of the DC-DC module 50. The second plug-in portion 63 of the second adapting member 60b is in a plug-in connection to the other direct current input port 541 of the DC-DC module 50. In other words, the second plug-in portion 63 is configured to be in the plug-in connection to the direct current input port 541 of the DC-DC module 50. It should be noted that, the plug-in connection between the first plug-in portions 62 and the direct current output ports 431 includes a fixed connection and an electrical connection, and the plug-in connection between the second plug-in portions 63 and the direct current input ports 541 includes an electrical connection and a fixed connection.

The first plug-in portions 62 are in the plug-in connection to the direct current output ports 431 of the AC-DC module 40, and the second plug-in portions 63 are in the plug-in connection to the direct current input ports 541 of the DC-DC module 50, so that the direct current output by the AC-DC module 40 can be transmitted to the DC-DC module 50 through the adapting member 60. A design of the plug-in connection has a simple and stable structure. This helps improve structural stability of the charging apparatus 100.

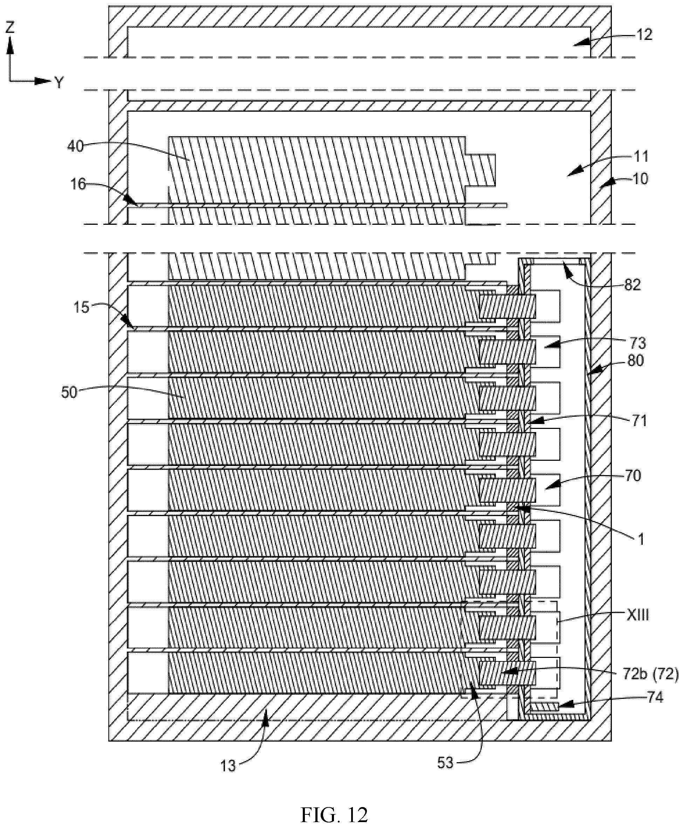

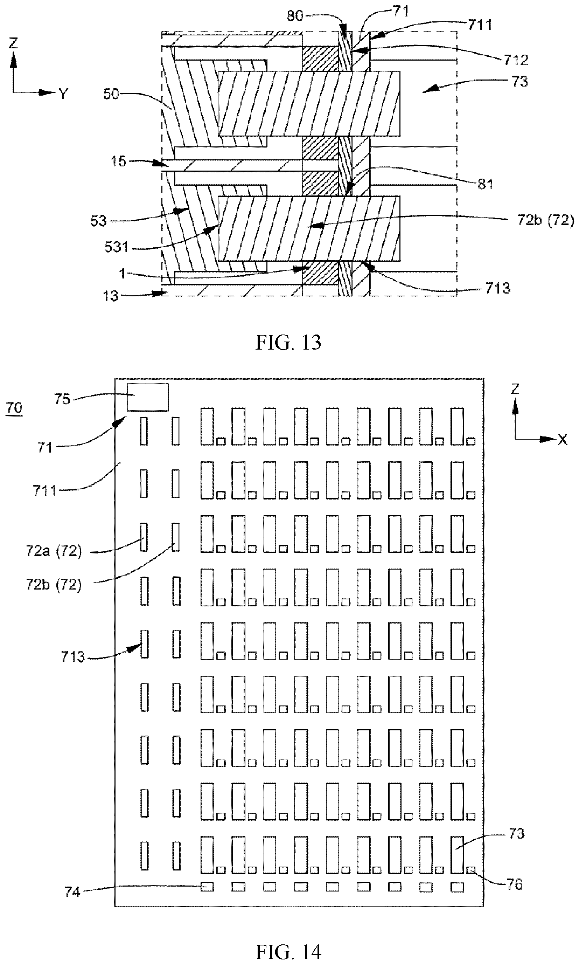

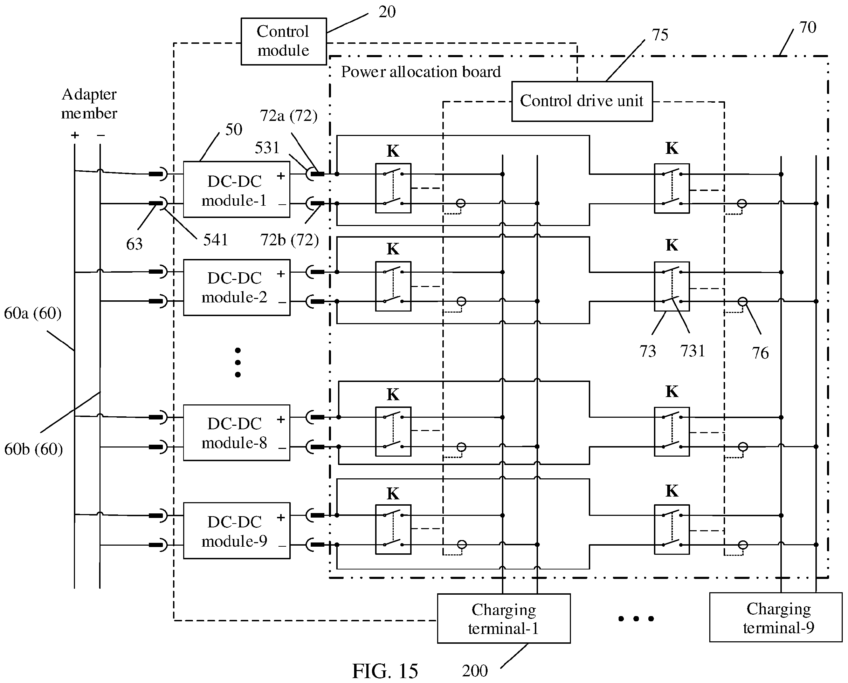

Refer to FIG. 11, FIG. 12, FIG. 13, FIG. 14, and FIG. 15. FIG. 11 is a schematic sectional view, along an F-F line, of a partial structure of the charging apparatus 100 (with the heat dissipation assembly 90 omitted) shown in FIG. 2. FIG. 12 is a schematic sectional view, along a G-G line, of a partial structure of the charging apparatus 100 (with the heat dissipation assembly 90 and the adapting members 60 omitted) shown in FIG. 2. FIG. 13 is an enlarged view of a part XIII of the charging apparatus 100 shown in FIG. 12. FIG. 14 is a schematic diagram depicting, in a positive direction of a Y axis, a structure of the power allocation board 70 of the charging apparatus 100 shown in FIG. 2. FIG. 15 is a block diagram of a partial electrical principle of mating between the control module 20, the DC-DC module 50, the adapting member 60, the power allocation board 70, and the charging terminal 200 of the charging apparatus 100 shown in FIG. 2.

As shown in FIG. 11, FIG. 12, and FIG. 13, in some embodiments, the housing 80 is accommodated in the first accommodation cavity 11. In the direction of the Y axis, the housing 80 is located on one side of the DC-DC module 50 and one side of the control module 20, and is spaced from the DC-DC module 50. In the direction of the X axis, the housing 80 is located on one side that is of the adapting member 60 and that faces away from the power distribution component 30, and is spaced from the adapting member 60. It may be understood that the AC-DC modules 40 and the DC-DC modules 50 are located outside the housing 80.

The housing 80 has an inner cavity. The housing 80 is provided with connection through holes 81. The connection through holes 81 penetrate through the housing 80. Specifically, in the direction of the Y axis, the connection through holes 81 penetrate through a cavity wall that is of the housing 80 and that faces the DC-DC module 50, and communicate with the inner cavity of the housing 80 and the first accommodation cavity 11. The connection through holes 81 are provided in pairs. There are a plurality of pairs of connection through holes 81. In the direction of the Z axis, the plurality of pairs of connection through holes 81 are arranged in sequence and spaced from each other. Two connection through holes 81 of each pair of connection through holes 81 are spaced from each other in the direction of the X axis. For example, there are nine pairs of connection through holes 81. In some other embodiments, there may alternatively be two, three, or more pairs of connection through holes 81.

In some embodiments, the housing 80 is provided with an air outlet 82 and an air inlet 83. Both the air outlet 82 and the air inlet 83 penetrate through the housing 80. Specifically, in the direction of the Y axis, the air outlet 82 penetrates through a cavity wall that is of the housing 80 and that faces the second accommodation cavity 12, and communicates with the inner cavity of the housing 80 and the first accommodation cavity 11. In the direction of the X axis, the air inlet 83 penetrates through a cavity wall that is of the housing 80 and that faces the adapting member 60, and communicates with the inner cavity of the housing 80 and the first accommodation cavity 11.

As shown in FIG. 13, FIG. 14, and FIG. 15, the power allocation board 70 is accommodated in the housing 80, and partially protrudes from the housing 80 and are connected to the plurality of DC-DC modules 50. In some embodiments, the power allocation board 70 includes a board body 71, input terminals 72, a plurality of switches 73, a plurality of second output ports 74, a control drive unit 75, and a plurality of sampling components 76. Specifically, the input terminals 72 are provided in pairs. There are a plurality of pairs of input terminals 72. For example, there are nine pairs of input terminals 72. In some other embodiments, there may alternatively be two, three, or more pairs of input terminals 72.

The input terminals 72, the switches 73, the second output ports 74, the control drive unit 75, and the sampling components 76 are all connected to the board body 71. The board body 71, the switches 73, the second output ports 74, the control drive unit 75, and the sampling components 76 are all accommodated in the housing 80. The plurality of pairs of input terminals 72 protrude from the housing 80 and are connected to the plurality of DC-DC modules 50 in a one-to-one correspondence. It may be understood that, a design of the housing 80 can prevent a large amount of heat emitted by the power allocation board 70 during operation from spreading to the AC-DC modules 40 and the DC-DC modules 50, and therefore avoid affecting operation of the AC-DC modules 40 and the DC-DC modules 50. Connections between the board body 71 and other components include a fixed connection and an electrical connection. The connections between the DC-DC module 50 and the input terminals 72 include a fixed connection and an electrical connection.

The power allocation board 70 receives, through the plurality of pairs of input terminals 72, the direct currents output by the plurality of DC-DC modules 50. The plurality of switches 73 are configured to allocate an output power of at least one DC-DC module 50 to at least one of the second output ports 74. The second output port 74 is configured to output one supply direct current. It may be understood that more output powers allocated to the second output port 74 indicates a higher power of the supply direct current output by the second output port 74. For example, there are nine second output ports 74. In some other embodiments, there may alternatively be two, three, or more second output ports 74.

The power supply direct current output by the second output port 74 of the charging apparatus 100 is transmitted to an electric device through the charging terminal 200, to supply power to the electric device. The second output port 74 is electrically connected to the charging terminal 200, so that the plurality of switches 73 can allocate the output power of the at least one DC-DC module 50 to the at least one charging terminal 200.

The control drive unit 75 may control the plurality of switches 73 to be turned off or turned on, to adjust the output power allocated to the second output port 74 and therefore adjust the power of the supply direct current output by the second output port 74. In this way, power consumption requirements of different electric devices are satisfied. The control drive unit 75 is electrically connected to the control module 20. The control module 20 controls operation of the control drive unit 75, to control operation of the power allocation board 70.

The sampling component 76 is configured to perform sampling detection on the switch 73 and output detection information. The control drive unit 75 may receive the detection information output by the sampling component 76, to determine whether the switch 73 can operate in a zero-current breaking state. If the control drive unit 75 determines that the switch 73 can operate in the zero-current breaking state, the control drive unit 75 controls the switch 73 to be reliably turned on.

As shown in FIG. 12, FIG. 13, and FIG. 14, for example, the board body 71 is a single-layer circuit board. In some other embodiments, the board body 71 may alternatively be a multilayer circuit board. The board body 71 includes a first connection surface 711 and a second connection surface 712. In the direction of the Y axis, the first connection surface 711 and the second connection surface 712 face away from each other. The second connection surface 712 is fastened to an inner wall surface of the housing 80.

In some embodiments, the board body 71 is provided with vias 713. The vias 713 penetrate through the board body 71. Specifically, the vias 713 penetrate through the board body 71 in the direction of the Y axis. The vias 713 are provided in pairs. For example, there are a plurality of pairs of vias 713. Specifically, there are nine pairs of vias 713. In the direction of the Z axis, the plurality of pairs of vias 713 are arranged in sequence and spaced from each other. In the direction of the X axis, two vias 713 of each pair of vias 713 are arranged in sequence and spaced from each other. In the direction of the Y axis, projections of all of the vias 713 overlap projections of all of the connection through holes 81 in a one-to-one correspondence.

As shown in FIG. 11, FIG. 12, and FIG. 14, the nine pairs of input terminals 72 pass through and are fastened in the nine pairs of vias 713 of the board body 71 in a one-to-one correspondence in a manner including but not limited to soldering or crimping, and are electrically connected to the board body 71. In other words, the input terminals 72 pass through and are fastened in the vias 713, and are electrically connected to the board body 71. It may be understood that, in the direction of the Z axis, the nine pairs of input terminals 72 are arranged in sequence and spaced from each other. In addition, in the direction of the X axis, two input terminals 72 of each pair of input terminals 72 are arranged in sequence and spaced from each other. The nine pairs of input terminals 72 pass through the nine pairs of connection through holes 81 of the housing 80 in a one-to-one correspondence, and the nine pairs of input terminals 72 are in a one-to-one plug-in connection to one pair of first output ports 531 of nine DC-DC modules 50. In other words, the input terminals 72 pass through the connection through holes 81 of the housing 80, and are in the plug-in connection to the first output ports 531 of the DC-DC module 50. In other words, the first output port 531 of the DC-DC module 50 is configured to be in the plug-in connection to the input terminal 72 of the power allocation board 70. The first output ports 531 of the DC-DC module 50 are in the plug-in connection to the input terminals 72 of the power allocation board 70, so that the power allocation board 70 can receive a direct current output by the DC-DC module 50 (namely, a direct current obtained through voltage conversion performed by the DC-DC module 50). It may be understood that the power allocation board 70 is accommodated in the housing 80, and the input terminals 72 protrude from the housing 80 and are in the plug-in connection to the first output ports 531 of the DC-DC module 50. It should be noted that the plug-in connection between the input terminals 72 and the first output ports 531 includes a fixed connection and an electrical connection.

The first output ports 531 of the DC-DC module 50 are in the plug-in connection to the input terminals 72 of the power allocation board 70, so that a direct current obtained through voltage conversion performed by the DC-DC module 50 can be transmitted to the power allocation board 70. Such a design has a simple structure, and can avoid complex wiring between the power allocation board 70 and the plurality of DC-DC modules 50. This helps improve reliability of connections between the power allocation board 70 and the DC-DC modules 50, thereby greatly improving use safety and manufacturability of the charging apparatus 100. This also helps reduce processing costs of the charging apparatus 100. In addition, this helps improve utilization of space between the power allocation board 70 and the plurality of DC-DC modules 50, and contributes to a miniaturized design of the charging apparatus 100.

In some embodiments, the charging apparatus 100 further includes a support member 1. The support member 1 is configured to limit movement of the first output port 531 of the DC-DC module 50 relative to the input terminal 72 of the power allocation board 70. Specifically, there are a plurality of support members 1. The plurality of support members 1 are fastened to an outer wall surface of the housing 80 in a manner including but not limited to threaded connection, soldering, gluing, or the like. The plurality of support members 1 are fastened and sleeved outside the plurality of pairs of input terminals 72 in a one-to-one correspondence in a manner including but not limited to snap-fit connection, threaded connection, soldering, or the like. For example, there are nine support members 1. In some other embodiments, there may alternatively be two, three, four, or more support members 1. In some other embodiments, there may alternatively be one support member 1, and all of the plurality of pairs of input terminals 72 penetrate through and are fastened to the support member 1.

It may be understood that, connection stress between the input terminals 72 and the first output ports 531 of the DC-DC module 50 can be dispersed to the housing 80 through the support members 1, because the plurality of support members 1 are fastened to the outer wall surface of the housing 80, and the plurality of support members 1 are fastened and sleeved outside the plurality of pairs of input terminals 72 in the one-to-one correspondence. A design of the support member 1 helps improve strength of the plug-in connection between the first output ports 531 and the input terminals 72, helps improve stability of connections between the power allocation board 70 and the DC-DC modules 50, and therefore helps improve structural stability of the charging apparatus 100.

As shown in FIG. 13, FIG. 14, and FIG. 15, in some embodiments, the control drive unit 75 is connected to the first connection surface 711 of the board body 71 in a manner including but not limited to soldering or plug-in connection. In the direction of the Z axis, the control drive unit 75 is located at one end of the plurality of pairs of input terminals 72, and is spaced from the plurality of pairs of input terminals 72. In some other embodiments, the control drive unit 75 may alternatively be connected to the second connection surface 712 of the board body 71.

In some embodiments, the plurality of switches 73 are connected to the first connection surface 711 of the board body 71. In some other embodiments, the plurality of switches 73 may alternatively be connected to the second connection surface 712 of the board body 71. In the direction of the X axis, the plurality of switches 73 are located on one side of the plurality of pairs of input terminals 72, and are spaced from the plurality of pairs of input terminals 72. The plurality of switches 73 are arranged in a matrix and spaced from each other. Specifically, in the direction of the X axis, a plurality of switches 73 are arranged in sequence and spaced from each other, to form one row of switches 73; and in the direction of the Z axis, a plurality of rows of switches 73 are arranged in sequence and spaced from each other. In other words, in the direction of the Z axis, a plurality of switches 73 are arranged in sequence and spaced from each other, to form one column of switches 73; and in the direction of the X axis, a plurality of columns of switches 73 are arranged in sequence and spaced from each other. In the direction of the X axis, the plurality of rows of switches 73 are located on sides of the plurality of pairs of input terminals 72 in a one-to-one correspondence, and are spaced from the plurality of pairs of input terminals 72.

For example, there are 81 switches 73. In the direction of the X axis, nine switches 73 are arranged in sequence and spaced from each other, to form one row of switches 73; and in the direction of the Z axis, nine rows of switches 73 are arranged in sequence and spaced from each other. In other words, in the direction of the Z axis, nine switches 73 are arranged in sequence and spaced from each other, to form one column of switches 73. In the direction of the X axis, nine columns of switches 73 are arranged in sequence and spaced from each other. In the direction of the X axis, the nine rows of switches 73 are located on sides of the nine pairs of input terminals 72 in a one-to-one correspondence, and are spaced from the nine pairs of input terminals 72. In some other embodiments, there may alternatively be two, four, six, or more switches 73. This is not specifically limited in this application.

The nine rows of switches 73 are electrically connected to the nine pairs of input terminals 72 in a one-to-one correspondence through the board body 71. It may be understood that each switch 73 of each row of switches 73 may receive a direct current output by one DC-DC module 50. The switches 73 all have an off state and an on state. When the switch 73 is in the on state, the direct current output by the DC-DC module 50 may flow from the input terminals 72 through the switch 73. In addition, each switch 73 is electrically connected to the control drive unit 75 through the board body 71.

In some embodiments, each switch 73 includes two sub-switches 731. The two sub-switches 731 are electrically connected to two input terminals 72 in one pair of input terminals 72, and are both electrically connected to the control drive unit 75. In some other embodiments, there may alternatively be one, three, or more sub-switches 731 in each switch 73. This is not specifically limited in this application. Each sub-switch 731 may be turned off or turned on. If each sub-switch 731 in the switch 73 is in an on state, the switch 73 is in the on state, and the direct current output by the DC-DC module 50 may flow from the input terminals 72 through the switch 73. If there is a sub-switch 731 in an off state in the switch 73, the direct current output by the DC-DC module 50 may not flow through the switch 73. The control drive unit 75 can control and drive each switch 731 to be turned off or turned on.

The plurality of sampling components 76 are connected to the first connection surface 711 of the board body 71 in a manner including but not limited to soldering, threaded connection, or plug-in connection. In some other embodiments, the plurality of sampling components 76 may alternatively be connected to the second connection surface 712 of the board body 71. For example, there are 81 sampling components 76. In the direction of the X axis, the 81 sampling components 76 are located, in a one-to-one correspondence, on sides that are of the 81 switches 73 and that face away from the input terminals 72, and are all spaced from a corresponding switch 73. In some other embodiments, there may alternatively be nine, ten, or more sampling components 76. That is, the plurality of sampling components 76 are electrically connected to the plurality of switches 73 in a one-to-one correspondence through the board body 71. Specifically, the sampling component 76 is electrically connected to one sub-switch 731 of the switch 73. In addition, the plurality of sampling components 76 are all electrically connected to the control drive unit 75. In some other embodiments, the plurality of sampling components 76 may alternatively be electrically connected to the plurality of rows of switches 73 in a one-to-one correspondence, and each sampling component 76 performs sampling detection on each switch 73 of each row of switches 73.

The plurality of second output ports 74 are connected to the first connection surface 711 of the board body 71 in a manner including but not limited to soldering, plug-in connection, or threaded connection. In some other embodiments, the plurality of second output ports 74 may alternatively be connected to the second connection surface 712 of the board body 71. In the direction of the X axis, the plurality of second output ports 74 are arranged in sequence and spaced from each other. In the direction of the Z axis, the plurality of second output ports 74 are located on one side of the plurality of switches 73, and are spaced from the plurality of switches 73. Specifically, in the direction of the Z axis, the plurality of second output ports 74 are located on sides of the plurality of columns of switches 73 in a one-to-one correspondence, and are all spaced from a corresponding column of switches 73. The plurality of second output ports 74 are electrically connected to the plurality of columns of switches 73 in a one-to-one correspondence. That is, the plurality of columns of switches 73 are electrically connected to the plurality of second output ports 74 in a one-to-one correspondence. Each switch 73 of each column of switches 73 is electrically connected to one second output port 74.

For example, in the direction of the X axis, the nine second output ports 74 are arranged in sequence and spaced from each other. In the direction of the Z axis, the nine second output ports 74 are located on sides of the nine columns of switches 73 in a one-to-one correspondence, and are all spaced from a corresponding column of switches 73. The nine second output ports 74 are electrically connected to the nine columns of switches 73 in a one-to-one correspondence. Nine switches 73 of each column of switches 73 are all electrically connected to one second output port 74. Each sampling component 76 is electrically connected between the switch 73 and the second output port 74 through the board body 71. It may be understood that, each switch 73 is electrically connected to one pair of input terminals 72 and one second output port 74, and each switch 73 is electrically connected to one DC-DC module 50 and one second output port 74.

The second output port 74 is electrically connected to the charging terminal 200. Therefore, it may be understood that each switch 73 is electrically connected to one DC-DC module 50 and one charging terminal 200. The sampling component 76 is electrically connected between the switch 73 and the charging terminal 200.

The power allocation board 70 outputs a plurality of power supply direct currents to the plurality of charging terminals 200 through the plurality of second output ports 74, to supply power to a plurality of electric devices. It may be understood that, the plurality of direct currents output by the plurality of DC-DC modules 50 may converge through each switch 73 of one column of switches 73 into one current at the second output port 74, and then the current may be transmitted from the second output port 74 to one charging terminal 200. Each power supply direct current is a convergent current of the plurality of direct currents output by the plurality of DC-DC modules 50. The control module 20 controls, by using the control drive unit 75, each switch 73 of each column of switches 73 to be turned off or turned on, to control a power of each power supply direct current. In this way, power consumption requirements of different electric devices are satisfied.

For example, the plurality of direct currents output by the plurality of DC-DC modules 50 may be equal. For ease of description, a magnitude of a power supply direct current output by each second output port 74 is defined as I₁, and a magnitude of a direct current of each DC-DC module 50 is defined as I₂. In this case, I₁ = nI₂ (1 ≤ n ≤ 9, and n represents a quantity of switches 73 in the on state among one column of switches 73). For example, if there are three switches 73 in the on state among one column of switches 73, I₁ = 3I₂. In some other embodiments, the plurality of direct currents output by the plurality of DC-DC modules 50 may alternatively be unequal. Therefore, the power allocation board 70 outputs the plurality of power supply direct currents through the plurality of second output ports 74, and adjusts a power of each power supply direct current through turn-off or turn-on of each switch 73 of each column of switches 73. To be specific, the control drive unit 75 controls each switch 73 of each column of switches 73 to be turned on or turned off, so that the output power of the at least one DC-DC module 50 can be allocated to the second output port 74, to adjust the power of the supply direct current output by the second output port 74.

It may be understood that, the control drive unit 75 controls the plurality of switches 73 of each column of switches 73 to be turned on or turned off, so that the output power of the DC-DC module 50 can be allocated to the at least one of the second output ports 74, to adjust the power of the supply direct current output by the second output port 74. In this way, the plurality of switches 73 can allocate the output power of the at least one DC-DC module 50 to the at least one of the second output ports 74.

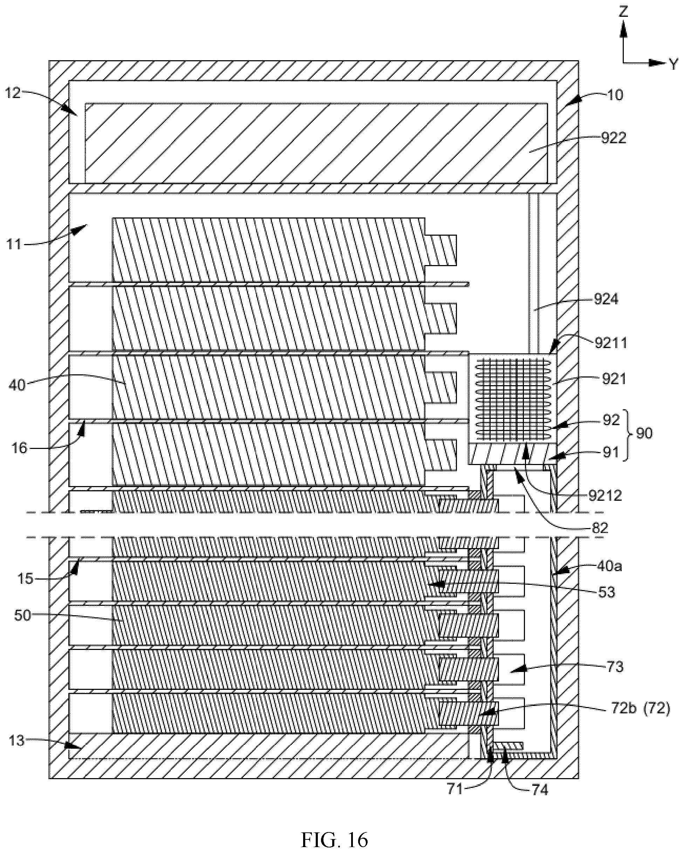

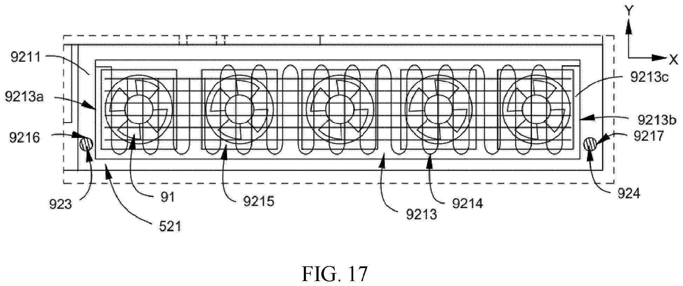

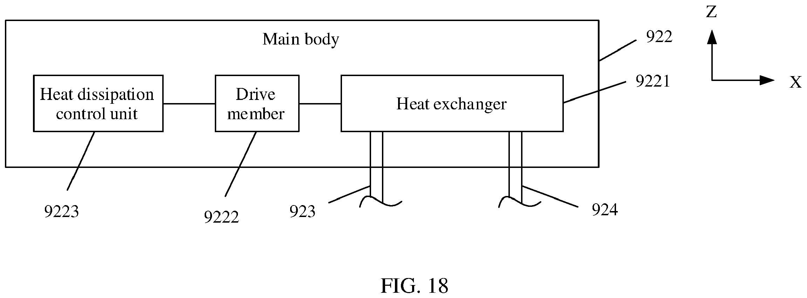

Refer to FIG. 16, FIG. 17, and FIG. 18. With reference to FIG. 2, FIG. 16 is a schematic sectional view, along a G-G line, of a partial structure of the charging apparatus 100 (with the adapting member 60 omitted) shown in FIG. 2. FIG. 17 is an enlarged view of a part XVII of the charging apparatus 100 shown in FIG. 3. FIG. 18 is a block diagram of a structure of mating between a main body 922, and a first pipe 923 and a second pipe 924, of a liquid cooling module 92 of the heat dissipation assembly 90 of the charging apparatus 100 shown in FIG. 17.

As shown in FIG. 2, FIG. 16, and FIG. 17, in some embodiments, the heat dissipation assembly 90 includes a fan 91 and the liquid cooling module 92. The fan 91 and the liquid cooling module 92 together perform heat dissipation on the power allocation board 70. The fan 91 is accommodated in the first accommodation cavity 11. The fan 91 is located outside the housing 80. In the direction of the X axis, the fan 91 is located on one side that is of the adapting member 60 and that faces away from a power distribution component 30, and is spaced from the adapting member 60. In the direction of the Y axis, the fan 91 is located on sides that are of a plurality of AC-DC modules 40 and that face the housing 80, and is spaced from the AC-DC modules 40. In the direction of the Z axis, the fan 91 is located on one side that is of the housing 80 and that faces the second accommodation cavity 12, and is fastened to the housing 80. In the direction of the Z axis, a projection of the fan 91 overlaps a projection of the air outlet 82 of the housing 80. For example, there are a plurality of fans 91. Specifically, there are five fans 91. In the direction of the X axis, the five fans 91 are arranged in sequence and are fastened. In some other embodiments, there may alternatively be one fan 91, or two or more fans 91. In some other embodiments, the fan 91 may alternatively be fastened to a cavity wall of the first accommodation cavity 11. The fan 91 is electrically connected to the control module 20 (as shown in FIG. 3). The control module 20 controls operation of the fan 91.

In some embodiments, the liquid cooling module 92 includes a cooling box 921, the main body 922, the first pipe 923, and the second pipe 924. The cooling box 921 is accommodated in the first accommodation cavity 11, and is fastened to the plurality of fans 91. Specifically, in the direction of the Z axis, the cooling box 921 is located on one side that is of the plurality of fans 91 and that faces away from the housing 80, and is fastened to the plurality of fans 91. The main body 922 is accommodated in the second accommodation cavity 12. The first pipe 923 passes through one through hole 17 of the protective housing 10, and two ends of the first pipe 923 are fastened to the cooling box 921 and the main body 922. The second pipe 924 passes through another through hole 17 of the protective housing 10, and two ends of the second pipe 924 are fastened to the cooling box 921 and the main body 922. In other words, the first pipe 923 and the second pipe 924 penetrate into the second accommodation cavity 12 from the first accommodation cavity 11. The two ends of each of the first pipe 923 and the second pipe 924 are fastened to the cooling box 921 and the main body 922.

It may be understood that both the fan 91 and the liquid cooling module 92 are located outside the housing 80. The cooling box 921 is configured to accommodate cooling liquid. The cooling box 921 is configured to accommodate the cooling liquid. For example, the cooling liquid is water. In some other embodiments, the cooling liquid may alternatively be other liquid with high thermal conductivity. The cooling liquid accommodated in the cooling box 921 may flow back to the cooling box 921 through the first pipe 923, the main body 922, and the second pipe 924.

The cooling box 921 includes a first box body surface 9211 and a second box body surface 9212. The first box body surface 9211 and the second box body surface 9212 face away from each other. The first box body surface 9211 faces away from the plurality of fans 91, and the second box body surface 9212 faces the plurality of fans 91 and is fastened to the plurality of fans 91.

The cooling box 921 is provided with a groove 9213. The groove 9213 extends from the first box body surface 9211 to the second box body surface 9212. The groove 9213 includes a first groove wall 9213a, a second groove wall 9213b, and a third groove wall 9213c. In the direction of the X axis, the first groove wall 9213a and the second groove wall 9213b are opposite to each other. The third groove wall 9213c is connected to the first groove wall 9213a and the second groove wall 9213b. In addition, in the direction of the Z axis, the third groove wall 9213c is located between the first box body surface 9211 and the second box body surface 9212 that are of the cooling box 921, and is spaced from the first box body surface 9211 and the second box body surface 9212.

A heat dissipation pipe 9214 is provided between the first groove wall 9213a and the second groove wall 9213b. In other words, the cooling box 921 includes the heat dissipation pipe 9214, and the heat dissipation pipe 9214 is accommodated in the groove 9213. For example, there are a plurality of heat dissipation pipes 9214, and in the direction of the Y axis, the plurality of heat dissipation pipes 9214 are arranged in sequence and spaced from each other. The cooling liquid accommodated in the cooling box 921 may flow in each heat dissipation pipe 9214. A design in which the heat dissipation pipe 9214 is accommodated in the groove 9213 helps improve utilization of space of the cooling box 921, thereby contributing to a miniaturized design of the cooling box 921; and helps reduce a weight of the cooling box 921, thereby contributing to a lightweight design of the cooling box 921.

The cooling box 921 is provided with a mounting hole 9215. The mounting hole 9215 extends in the direction of the Z axis and has two openings. One opening is located on the third groove wall 9213c of the groove 9213, and the other opening is located on the second box body surface 9212 of the cooling box 921. The groove 9213 communicates with the mounting hole 9215. For example, there are five mounting holes 9215. In the direction of the X axis, the five mounting holes 9215 are arranged in sequence and spaced from each other. In the direction of the Z axis, projections of the five fans 91 on the cooling box 921 are located in the five mounting holes 9215 in a one-to-one correspondence. In other words, the projection of the fan 91 on the cooling box 921 is located in the mounting hole 9215. In some other embodiments, there may alternatively be one mounting hole 9215, or two or more mounting holes 9215.

The cooling box 921 is provided with a first connection hole 9216 and a second connection hole 9217. The first connection hole 9216 and the second connection hole 9217 are located on two opposite sides of the groove 9213, and are both spaced from the groove 9213. Both the first connection hole 9216 and the second connection hole 9217 extend from the first box body surface 9211 to the second box body surface 9212, and communicate with an inner cavity of the cooling box 921.

As shown in FIG. 2, FIG. 17, and FIG. 18, the main body 922 is accommodated in the second accommodation cavity 12. The main body 922 includes a heat exchanger 9221, a drive member 9222, and a heat dissipation control unit 9223. In other words, the liquid cooling module 92 includes the heat exchanger 9221. The drive member 9222 is fastened to the heat exchanger 9221, and is electrically connected to the heat dissipation control unit 9223. The heat dissipation control unit 9223 is electrically connected to the control module 20.

The first pipe 923 extends in the direction of the Z axis and passes through one through hole 17 of the protective housing 10. One end of the first pipe 923 is fastened in the first connection hole 9216 of the cooling box 921, and the other end is fastened to the heat exchanger 9221. The second pipe 924 extends in the direction of the Z axis and passes through another through hole 17 of the protective housing 10. One end of the second pipe 924 is fastened in the second connection hole 9217 of the cooling box 921, and the other end is fastened to the heat exchanger 9221. Two ends of each of the plurality of heat dissipation pipes 9214 of the cooling box 921 communicate with the first pipe 923 and the second pipe 924. In other words, the two ends of the heat dissipation pipe 9214 communicate with the first pipe 923 and the second pipe 924. It may be understood that the cooling box 921 is fastened to the heat exchanger 9221 through the first pipe 923 and the second pipe 924. The cooling liquid accommodated in the cooling box 921 may flow back to the cooling box 921 through the first pipe 923, the heat exchanger 9221, and the second pipe 924. The cooling liquid accommodated in the cooling box 921 may flow from the first pipe 923 to the second pipe 924 through the plurality of heat dissipation pipes 9214. In other words, the cooling liquid flows from the first pipe 923 to the second pipe 924 through the heat dissipation pipe 9214.

The drive member 9222 is configured to drive the cooling liquid to flow. For example, the drive member 9222 is a water pump. The heat exchanger 9221 is configured to perform heat dissipation on the cooling liquid. The heat dissipation control unit 9223 is configured to control a rotation speed of the drive member 9222. The heat dissipation control unit 9223 is electrically connected to the control module 20 (as shown in FIG. 3). The control module 20 controls, by using the heat dissipation control unit 9223, operation of the drive member 9222. The control module 20 controls operation of the liquid cooling module 92.

During operation of the power allocation board 70, the power allocation board 70 emits a large amount of heat. As a result, a temperature of air around the power allocation board 70 increases, so that high-temperature gas is formed. The fan 91 may draw air, so that the high-temperature gas is blown out of the housing 80 through the air outlet 82 and passes through the plurality of heat dissipation pipes 9214 via the mounting hole 9215 of the cooling box 921. Each heat dissipation pipe 9214 absorbs heat from the high-temperature gas by using the cooling liquid flowing in the heat dissipation pipe 9214, to cool the high-temperature gas. In other words, the fan 91 may draw air, so that the high-temperature gas is blown out of the housing 80 through the air outlet 82 to the cooling box 921. In this way, the cooling liquid accommodated in the cooling box 921 absorbs the heat from the high-temperature gas, to cool the high-temperature gas. As a result, the heat emitted by the power allocation board 70 is absorbed by the cooling liquid accommodated in the cooling box 921, so that the heat dissipation of the power allocation board 70 is implemented. The heat dissipation manner is simple and easy to design, and has relatively high universality. Air inside the first accommodation cavity 11 (namely, air outside the housing 80) may flow into the housing 80 from the air inlet 83 (as shown in FIG. 11) of the housing 80, to ensure balance of air pressure inside the housing 80.

It may be understood that, the fan 91 is configured for the heat emitted by the power allocation board 70 during operation to be absorbed by the cooling liquid flowing in the heat dissipation pipe 9214. The fan may drive air to flow, so that air with the heat emitted by the power allocation board 70 during operation flows through the heat dissipation pipe 9214. In this way, the heat emitted by the power allocation board 70 during operation can be absorbed by the cooling liquid flowing in the heat dissipation pipe 9214. A structure is simple and easy to design.

It should be noted that, after the cooling liquid flowing in each heat dissipation pipe 9214 absorbs the heat from the high-temperature gas, the cooling liquid that already absorbs the heat is driven by the drive member 9222 to be transmitted from the heat dissipation pipes 9214 to the heat exchanger 9221 through the first pipe 923 in sequence. The heat exchanger 9221 absorbs heat from the cooling liquid, and dissipates the heat to an external environment, to cool the cooling liquid. In other words, the heat exchanger 9221 may perform heat dissipation on the cooling liquid. The cooling liquid on which heat dissipation is already performed by the heat exchanger 9221 is driven by the drive member 9222 to flow from the heat exchanger 9221 to the heat dissipation pipe 9214 of the cooling box 921 through the second pipe 924. In this way, the heat exchanger 9221 performs heat dissipation on the cooling liquid and the drive member 9222 drives the cooling liquid, to ensure that the cooling liquid flowing in the heat dissipation pipe 9214 always remains at a relatively low temperature, and therefore ensure that the cooling liquid flowing in the heat dissipation pipe 9214 can always absorb a large amount of heat emitted by the power allocation board 70 during operation. This helps improve heat dissipation efficiency of the power allocation board 70.

In this case, the cooling box 921 is configured to accommodate the cooling liquid, the fan 91 is configured for the heat emitted by the power allocation board 70 during operation to be absorbed by the cooling liquid, and the heat exchanger 9221 is configured to perform heat dissipation on the cooling liquid. The cooling liquid may flow in the cooling box 921, the first pipe 923, the heat exchanger 9221, and the second pipe 924. The fan 91 may be for the heat emitted by the power allocation board 70 during operation to be absorbed by the cooling liquid accommodated in the cooling box 921, so that heat dissipation of the power allocation board 70 is implemented. The heat exchanger 9221 may perform heat dissipation on cooling liquid that already absorbs the heat emitted by the power allocation board 70 during operation, to ensure that the cooling liquid always remains at the relatively low temperature. In this way, the cooling liquid can continuously absorb the heat emitted by the power allocation board 70 during operation, to continuously perform heat dissipation on the power allocation board 70.

In this case, a solution that uses a combination of air and liquid to perform heat dissipation on the power allocation board 70 helps increase a heat dissipation speed of the power allocation board 70, and helps increase a current density of the power allocation board 70 (for example, increase current densities of a plurality of switches 73), and therefore helps increase the power supply direct current transmitted by a second output port 74 of the power allocation board 70 to the electric device and improve charging efficiency of the charging apparatus 100. In addition, this helps reduce costs and a size of the power allocation board 70, contributes to a miniaturized design of the power allocation board 70, and therefore contributes to the miniaturized design of the charging apparatus 100.

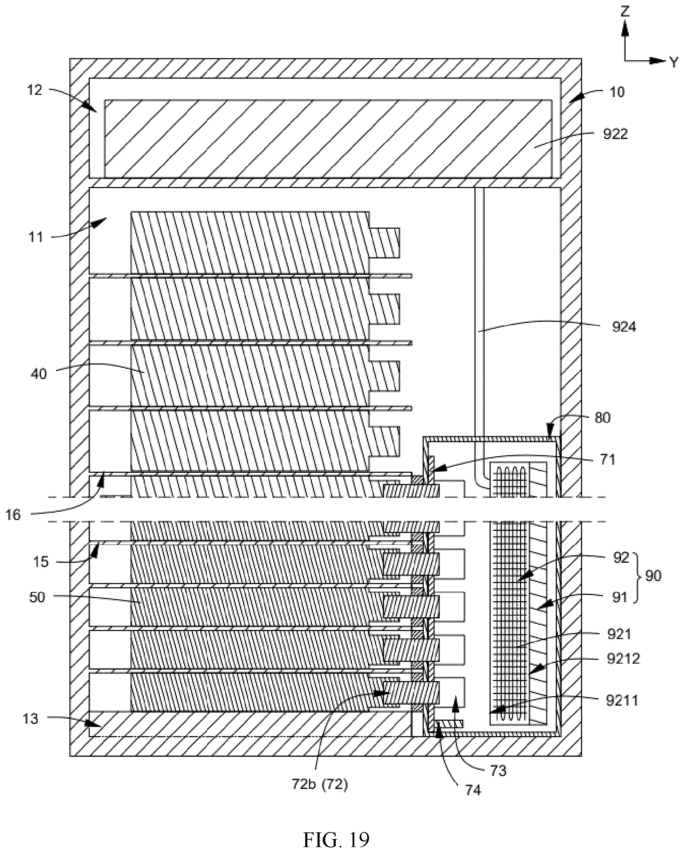

Refer to FIG. 19. With reference to FIG. 16 and FIG. 18, FIG. 19 is a schematic sectional view, along a G-G line, of a partial structure of the charging apparatus 100 (with the adapting member 60 omitted) shown in FIG. 2 according to another embodiment.

In some other embodiments, the fan 91 and the cooling box 921 may alternatively be accommodated in the housing 80. The air outlet 82 and the air inlet 83 (as shown in FIG. 11) of the housing 80 may be omitted. The heat dissipation assembly 90 performs heat dissipation on the power allocation board 70 in different manners. Specifically, the fan 91 and the cooling box 921 are accommodated in the housing 80. The fan 91 is fastened to the cooling box 921. In the direction of the Y axis, the cooling box 921 is located between the fan 91 and the plurality of switches 73, and is spaced from the plurality of switches 73. In the direction of the Y axis, a surface that is of the fan 91 and that faces away from the cooling box 921 is spaced from an inner wall surface of the housing 80. In some other embodiments, the cooling box 921 and the fan 91 may alternatively be located at any other position in the housing 80. For structures of the fan 91 and the cooling box 921 and a connection relationship between the fan 91 and the cooling box 921, refer to the foregoing descriptions. Details are not described again.

The main body 922 is accommodated in the second accommodation cavity 12. The main body 922 includes the heat exchanger 9221, the drive member 9222, and the heat dissipation control unit 9223. The drive member 9222 is fastened to the heat exchanger 9221, and is electrically connected to the heat dissipation control unit 9223. It may be understood that the heat exchanger 9221 is located outside the housing 80.

The first pipe 923 is fastened to the cooling box 921, and penetrates from an inside of the housing 80 into the first accommodation cavity 11 through the housing 80, and then the first pipe 923 penetrates into the second accommodation cavity 12 from the first accommodation cavity 11. The first pipe 923 is fastened to the heat exchanger 9221. The second pipe 924 is fastened to the cooling box 921, and penetrates from the inside of the housing 80 into the first accommodation cavity 11 through the housing 80, and then the second pipe 924 penetrates into the second accommodation cavity 12 from the first accommodation cavity 11. The second pipe 924 is fastened to the heat exchanger 9221. In other words, both the first pipe 923 and the second pipe 924 are fastened to the cooling box 921, and protrude from the housing 80 and are fastened to the heat exchanger 9221.

The cooling box 921 is configured to accommodate cooling liquid. The cooling liquid accommodated in the cooling box 921 may flow back to the cooling box 921 through the first pipe 923, the heat exchanger 9221, and the second pipe 924. The drive member 9222 is configured to drive the cooling liquid to flow. The heat exchanger 9221 is configured to perform heat dissipation on the cooling liquid. The heat dissipation control unit 9223 is configured to control the rotation speed of the drive member 9222.

During operation of the power allocation board 70, the power allocation board 70 emits a large amount of heat and the heat spreads to air inside the housing 80. The fan 91 may cause the air inside the housing 80 to flow, so that a disturbing flow is formed, and the heat emitted by the power allocation board 70 flows to the cooling box 921 along with the air. In this way, the cooling liquid accommodated in the cooling box 921 can absorb the heat emitted by the power allocation board 70. The cooling liquid that already absorbs the heat is driven by the drive member 9222 to flow from the cooling box 921 to the heat exchanger 9221 through the first pipe 923. The heat exchanger 9221 located outside the housing 80 may absorb heat from the cooling liquid, and dissipate the heat to an external environment. In other words, the heat exchanger 9221 located outside the housing 80 performs heat dissipation on the cooling liquid, to ensure a uniform temperature within the air inside the housing 80. In this way, even heat dissipation of the air inside the housing 80 is implemented, and even heat dissipation of the power allocation board 70 is implemented.

Compared with the solution of performing heat dissipation on the power allocation board 70 in the embodiment shown in FIG. 17, the solution of performing the heat dissipation on the power allocation board 70 in this embodiment not only helps increase a heat dissipation speed of the power allocation board 70, but also ensures even heat dissipation of the power allocation board 70, thereby increasing a current density of the power allocation board 70 (for example, increasing current densities of the plurality of switches 73), and increasing the power supply direct current output by the power allocation board 70 through the second output port 74. This helps improve charging efficiency of the charging apparatus 100. In addition, costs and a size of the power allocation board 70 are further reduced, which contributes to a miniaturized design of the power allocation board 70 and therefore contributes to the miniaturized design of the charging apparatus 100.

Refer to FIG. 1, FIG. 13, FIG. 14, and FIG. 15 again. An embodiment of this application provides a charging apparatus 100. The charging apparatus 100 includes a plurality of alternating current to direct current conversion AC-DC modules 40, a plurality of direct current to direct current conversion DC-DC modules 50, and a power allocation board 70. The AC-DC module 40 is configured to convert an alternating current into a direct current. The DC-DC module 50 is configured to perform voltage conversion on the direct current output by the AC-DC module 40, and the DC-DC module 50 includes first output ports 531. The power allocation board 70 includes input terminals 72, a plurality of switches 73, and a plurality of second output ports 74. The plurality of switches 73 are configured to allocate an output power of at least one DC-DC module 50 to at least one of the second output ports 74. The first output port 531 of the DC-DC module 50 is configured to be in a plug-in connection to the input terminal 72 of the power allocation board 70.

In the charging apparatus 100 provided in this embodiment of this application, the AC-DC module 40 may receive an alternating current output by an external power supply, and convert the alternating current into a direct current. The DC-DC module 50 may receive the direct current output by the AC-DC module 40, and may perform voltage conversion on the direct current output by the AC-DC module 40. The first output ports 531 of the DC-DC module 50 are in the plug-in connection to the input terminals 72 of the power allocation board 70, so that a direct current obtained through voltage conversion performed by the DC-DC module 50 can be transmitted to the power allocation board 70. The power allocation board 70 may allocate the output power of the at least one DC-DC module 50 to the at least one of the second output ports 74 by using the plurality of switches 73. The second output port 74 may output a power supply direct current to an electric device, to supply power to the electric device. The plurality of switches 73 are turned on or turned off, so that output powers allocated to different second output ports 74 can be controlled, and therefore magnitudes of power supply direct currents output by the different second output ports 74 can be controlled. In this way, the charging apparatus 100 can meet power supply requirements of different electric devices. In addition, this helps improve power utilization of the charging apparatus 100.

The first output ports 531 of the DC-DC module 50 are in the plug-in connection to the input terminals 72 of the power allocation board 70, so that the direct current obtained through voltage conversion performed by the DC-DC module 50 can be transmitted to the power allocation board 70. Such a design has a simple structure, and can avoid complex wiring between the power allocation board 70 and the plurality of DC-DC modules 50. This helps improve reliability of connections between the power allocation board 70 and the DC-DC modules 50, thereby greatly improving use safety and manufacturability of the charging apparatus 100. This also helps reduce processing costs of the charging apparatus 100. In addition, this helps improve utilization of space between the power allocation board 70 and the plurality of DC-DC modules 50, and contributes to a miniaturized design of the charging apparatus 100.

## Claims

1. A charging apparatus, wherein the charging apparatus comprises a plurality of alternating current to direct current conversion AC-DC modules, a plurality of direct current to direct current conversion DC-DC modules, and a power allocation board, wherein
the AC-DC module is configured to convert an alternating current into a direct current;
the DC-DC module is configured to perform voltage conversion on the direct current output by the AC-DC module, and the DC-DC module comprises first output ports;
the power allocation board comprises input terminals, a plurality of switches, and a plurality of second output ports, and the plurality of switches are configured to allocate an output power of at least one DC-DC module to at least one of the second output ports; and
the first output port of the DC-DC module is configured to be in a plug-in connection to the input terminal of the power allocation board.

2. The charging apparatus according to claim 1, wherein the DC-DC module comprises a connector, and the connector is provided with the first output ports.

3. The charging apparatus according to claim 1, wherein the charging apparatus further comprises a support member, and the support member is configured to limit movement of the first output port of the DC-DC module relative to the input terminal of the power allocation board.

4. The charging apparatus according to claim 1, wherein the charging apparatus further comprises a fan and a liquid cooling module, the liquid cooling module comprises a cooling box, a first pipe, a second pipe, and a heat exchanger, the cooling box is connected to the heat exchanger through the first pipe and the second pipe, the cooling box is configured to accommodate cooling liquid, the fan is configured for heat emitted by the power allocation board during operation to be absorbed by the cooling liquid, and the heat exchanger is configured to perform heat dissipation on the cooling liquid.

5. The charging apparatus according to claim 4, wherein the cooling box comprises a heat dissipation pipe, two ends of the heat dissipation pipe communicate with the first pipe and the second pipe, and the cooling liquid flows from the first pipe to the second pipe through the heat dissipation pipe.

6. The charging apparatus according to claim 4 or 5, wherein the charging apparatus further comprises a housing, the AC-DC modules and the DC-DC modules are located outside the housing, the power allocation board is accommodated in the housing, and the input terminal protrudes from the housing and is in the plug-in connection to the first output port of the DC-DC module.

7. The charging apparatus according to claim 6, wherein the fan and the liquid cooling module are located outside the housing, and the housing is provided with an air outlet and an air inlet.

8. The charging apparatus according to claim 6, wherein the fan and the cooling box are accommodated in the housing, and the first pipe and the second pipe protrude from the housing and are fastened to the heat exchanger.

9. The charging apparatus according to any one of claims 1 to 4, wherein the AC-DC module comprises direct current output ports, the DC-DC module comprises direct current input ports, the charging apparatus further comprises a plug-in member, the plug-in member comprises first plug-in portions and second plug-in portions, the first plug-in portion is configured to be in a plug-in connection to the direct current output port of the AC-DC module, and the second plug-in portion is configured to be in a plug-in connection to the direct current input port of the DC-DC module.

10. A charging device, wherein the charging device comprises the charging apparatus according to any one of claims 1 to 9 and a plurality of charging terminals, and the charging terminal is configured to electrically connect to the second output port.
